Europäisches Patentamt

European Patent Office

Office européen des brevets

(11) Publication number: **0 461 405 A2**

## EUROPEAN PATENT APPLICATION

(21) Application number: **91107744.4**

(22) Date of filing: **14.05.91**

(51) Int. Cl.5: **H03K 19/013**, H03K 19/088

(30) Priority: **13.06.90 US 537401**

(43) Date of publication of application:
**18.12.91 Bulletin 91/51**

(84) Designated Contracting States:
**DE FR GB**

(71) Applicant: **International Business Machines
Corporation
Old Orchard Road
Armonk, N.Y. 10504(US)**

(72) Inventor: **Goetschel, Christian J.
30 Pennington Drive
Burlington, VT 05401(US)**

(74) Representative: **Gaugel, Heinz, Dipl.-Ing.
IBM Deutschland GmbH Schönaicher
Strasse 220
W-7030 Böblingen(DE)**

(54) **A transistor/transistor logic circuit having a clamped output.**

(57) The present invention describes a unique so-called transistor/transistor logic (TTL) arrangement which uses a diode-resistor network (20, 23) to develop a stable clamping reference voltage for the open collector circuit portion of the TTL arrangement. The open collector circuit of the present invention basically uses an open collector output transistor (10) whose base is coupled through a resistor network (21, 22) to a second transistor (15) so that the second transistor (15) will go into saturation so as to direct a reference current through the diode-resistance network (20, 23) and thus prevent the open collector output transistor (10) from saturating.

Fig. 1.

EP 0 461 405 A2

This invention relates generally to transistor/transistor logic circuits and more particularly to a transistor/transistor logic circuit using a diode resistance network to develop a clamped reference voltage.

In some semiconductor circuits Schottky clamping diodes, known to the art, are not available because of the technology used to produce the semiconductor circuit. Additionally, in some open collector output arrangements it is necessary that the clamping reference voltage be independent of the drive current while still providing a circuit readily incorporated into an integrated structure.

The present invention describes a unique so-called transistor/transistor logic (TTL) arrangement which uses a diode-resistor network to develop a stable clamping reference voltage for the open collector circuit portion of the TTL arrangement. The open collector circuit of the present invention basically uses an open collector output transistor whose base is coupled through a resistor network to a second transistor so that the second transistor will go into saturation so as to direct a reference current through the diode-resistance network and thus prevent the open collector output transistor from saturating.

This is particularly accomplished by having the base electrode of the open collector output transistor coupled to a current source through a first resistor and to the base electrode of the second transistor through both the first resistor and a second resistor and to the collector of the second transistor through both the first resistor and a third resistor so that when the emitters of the two transistors are coupled in common the voltage to which the output line becomes clamped is directly related to the saturation voltage of the second transistor and the base voltage of the first transistor. When the second transistor goes into saturation it establishes a fixed current flow through the first and third resistors which causes a reference voltage to be set at the current source. This reference voltage is translated through the diode to appear as a clamp voltage at the output to prevent the open collector output transistor from becoming saturated. This assures that the voltage to which the output line becomes clamped is independent of the drive current.

These and other general and specific objects, advantages and aspects of the invention will eventually become apparent when reference is made to the following detailed description considered in conjunction with the accompanying drawings.

Fig. 1 shows the circuit of the preferred embodiment in which a transistor/transistor logic open collector circuit is provided which develops its own clamping reference voltages even without a well defined current input source.

Fig. 2 shows the collector voltage of the output transistor of the present invention versus its base current drive.

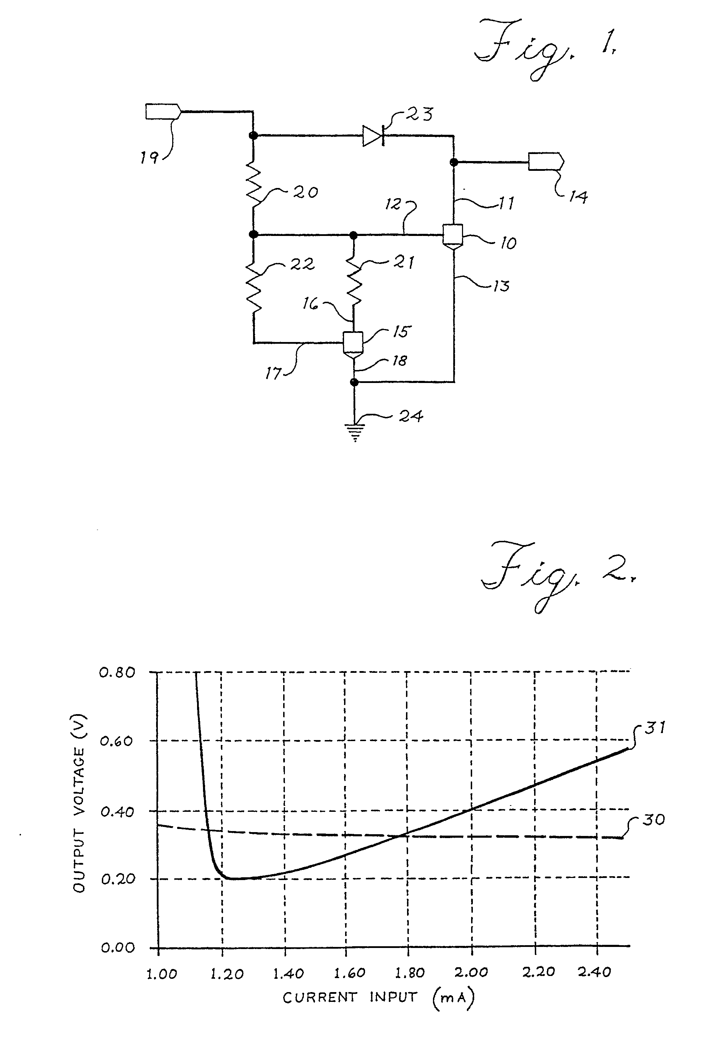

Referring now to the drawings and more particularly to Fig. 1, there is shown in schematic form the preferred embodiment of the present invention. This Fig. 1 shows a bipolar transistor-transistor logic (TTL) open collector output circuit which develops its own clamping reference voltage independent of the drive current with only two transistors, three resistors and a diode. In this Fig., output transistor 10 has its collector 11 coupled to an output 14 and its base 12 coupled to an input current source 19 via a first resistor 20. The base 12 of transistor 10 is also coupled to the collector 16 and the base 17 of a current control transistor 15 via second and third resistors 22 and 21 respectively. The emitters 13 and 18 of the transistors 10 and 15 respectively are coupled to a ground node 24. The input current source 19 is also coupled to the output 14 through a diode 23.

The described circuit operates as follows; When drive current is applied by the input current source 19 the transistors 10 and 15 both begin to turn on with the output transistor 10 turning on more quickly than the current control transistor 15. This faster turn on of transistor 10 occurs because its base is coupled to the current source 19 only through resistor 20 while transistor 15 has its base 17 coupled to the current source 19 through both resistors 20 and 22. By controlling the size of resistor 22 the time required for turning on transistor 15 can be regulated.

When transistor 10 turns on it begins pulling down the output 14. However, as the current control transistor 15 turns on it draws current through resistor 21 lowering the base drive current of transistor 10. The size of transistor 15 and the size of resistor 22 is selected such that the transistor 15 rapidly goes into saturation, i.e. the voltage at the collector 16 of the transistor 15 is pulled below that of its base 17. The saturation voltage of transistor 15 and the base voltage of transistor 10 establishes a reference current in resistor 21. This reference current is the primary current in resistor 20, for the base current in transistor 10 and the current through resistor 22 is made small by design. This sets a reference voltage at node 19 which is fed through diode 23 to the collector of transistor 10 thus providing a clamped level at output 14 which is stable over a wide output loading range. The simplicity of the circuit renders it capable of being implemented with many different integrated semiconductor processes even though the processes are not compatible with the formation of Schottky diodes.

Fig. 2 shows a curve 30 representing the clamped output voltage of output 14 for varying base drive current levels applied to the output transistor 10 as shown in the circuit of the diode. Also shown in Fig. 2 is the output voltage versus current input curve 31 of a typical prior art Schottky diode clamped circuit.

Fig. 2 shows, as a dashed line, a curve 30 which represents the resultant clamped output voltage of the present invention as measured at the output line 14 as the input current applied to the current source 19 varies over a wide range. The flatness of the curve 30 shows that the clamped output voltage remains in a very narrow range even when the input current changes over a wide range. This shows that the clamped output voltage of the present invention is substantially independent of the input current.

Also shown in Fig. 2, as a solid line, is a comparable curve 31 for a typical prior art diode clamped circuit. This curve 31 shows that the output voltage varies greatly with respect to the input current and thus is directly dependent thereon.

Furthermore, the circuit of the present invention has low impedance when the circuit is pulling the output down and when the output is in fact pulled down. The circuit of the present invention also has minimum delay and when in an integrated circuit prevents a substrate voltage which exceeds the specified maximum device terminal voltage limit from being applied.

Thus, it has been described a unique transistor/transistor open collector logic circuit which uses a resistance network to develop a clamping reference voltage.

It should be noted that the bipolar transistor can be silicon, germanium silicon-germanium or other heterobipolar transistor (HBT) material.

## Claims

1. A transistor circuit for clamping the voltage of an output line at a selected voltage comprising:

   a current input (19) connected to an output line (14) through a forward biased diode (23),

   said input (19) being further connected to the base electrode of an output transistor (10) having a defined saturation voltage through a first resistor (20), and to the base electrode of a current control transistor (15), through the first resistor (20) and a second resistor (22), and to the output of said current control transistor (15), through said first resistor (20) and a third resistor (21), the saturation voltage of said current control transistor (15) and the base voltage of said output transistor (10) establishing a reference current through the third resistor (21),

said second resistor (22) having a resistance significantly greater than said first resistor (20) the emitters of said output and current control transistors (10, 15) being connected in common, and

the collector of said output transistor (10) being coupled to the output line (14), said diode (23) and said first resistor (20) translating said reference current to a reference voltage clamping the collector of the output transistor (10) at a selected voltage.

2. The circuit of claim 1 wherein said current control transistor (15) has a saturation voltage level below the base voltage of the output transistor (10) to limit the current applied to the base of said first transistor at a level directly related to the saturation voltage of the current control transistor.

3. The circuit of claim 1 or 2 wherein said emitters are coupled to ground.

4. The circuit of anyone of the claims 1 to 3 where one of said transistors (10, 15) is formed of a hetro-bipolar transistor material.

*Fig. 1.*

*Fig. 2.*